# EUROPEAN PATENT APPLICATION

(11) **EP 4 395 484 A1**
(43) Date of publication of application: **03.07.2024**
(21) Application number: 23215724.8
(22) Date of filing: 12.12.2023
(51) Int. Cl.: H05K 7/18

(54) **SIDE RACK**

(30) Priority: 30.12.2022 US 202263477998 P; 04.12.2023 US 202318527481
(71) Applicant: Schneider Electric IT Corporation, Foxboro, MA 02035 (US)
(72) Inventor: Norton, Trevor William, ANDOVER, 01810 (US); Zhou, Fu, SHANGHAI, 201203 (CN); Zhu, Jie, SHANGHAI, 201203 (CN); Zeng, Xiaoying, SHANGHAI, 201203 (CN); LU, Hao, SHANGHAI, 200237 (CN)
(74) Representative: Plasseraud IP

(57) **Abstract**

A side rack includes a chassis, a first horizontal support coupled to the chassis, a second horizontal support coupled to the chassis, and a third horizontal support coupled to the chassis. The first horizontal support is configured to be coupled to a first piece of equipment, the second horizontal support is configured to be coupled to the first piece of equipment, and the third horizontal support is configured to be coupled to a second piece of equipment.

## Description

### BACKGROUND OF DISCLOSURE

### Field of Disclosure

Aspects of the present disclosure relate generally to equipment racks, and more particularly to an auxiliary side rack.

### Discussion of Related Art

Auxiliary side racks, sometimes referred to as "sidecar racks," are used for cable management and similar peripheral components. Existing racks do not facilitate vertical mounting of equipment. Further, existing racks do not have cable passthroughs between equipment in the rack, with the passthroughs being positioned on the sides of the rack.

Sidecar racks are typically positioned adjacent to a main equipment rack. Such sidecar racks do not support IT or power equipment. Existing sidecar racks are too narrow to arrange devices in a typical horizontal orientation. Instead, sidecar racks are configured to hold peripheral components, such as cables and peripheral hardware.

### BRIEF DESCRIPTION OF DRAWINGS

The accompanying drawings are not intended to be drawn to scale. In the drawings, each identical or nearly identical component that is illustrated with various figures, are represented by a line numeral. For purposes of clarity, not every component may be labeled in every drawing. In the drawings:
FIG. 1 is a front view of an equipment rack and an auxiliary side rack of an embodiment of the present disclosure;
FIG. 2 is a perspective view of the equipment rack and the auxiliary side rack shown in FIG. 1;
FIG. 3 is a perspective view of the auxiliary side rack with doors of the auxiliary side rack being shown in a closed position;
FIG. 4 is a perspective view of the auxiliary side rack shown in FIG. 3 with the doors being shown in an open position;
FIG. 5 is a front view of the auxiliary side rack with a front door removed to reveal an interior of the auxiliary side rack;
FIG. 6 is an exploded perspective view of the auxiliary side rack with the doors removed;
FIG. 7 is a side view of the auxiliary side rack;
FIG. 8 is another perspective view of the auxiliary side rack with the doors being shown in a closed position;
FIG. 9 is a front view of the auxiliary side rack shown in FIG. 5 supporting electronic equipment;
FIG. 10 is a perspective view of the auxiliary side rack showing electronic equipment being installed in the auxiliary side rack;
FIGS. 11-14 are perspective views showing details of the auxiliary side rack;
FIG. 15 is a perspective view of a kit having components of the auxiliary side rack; and
FIG. 16 is an enlarged view of a bracket used to secure the auxiliary side rack to the equipment rack.

### DETAILED DESCRIPTION

Embodiments of the present disclosure are directed to an auxiliary side rack configured to support power and/or IT equipment. The auxiliary side rack allows space for cable "pass through" between power and/or IT equipment. In one embodiment, an auxiliary side rack includes a first horizontal rail or support and a second horizontal rail or support for a first piece of electronic equipment, and a third horizontal rail or support for a second piece of electronic equipment. The auxiliary side rack also includes a cable passthrough between the second rail and the third rail.

In some embodiments, an auxiliary side rack includes a 235 millimeter (mm) wide chassis that is mounted on and connects with a standard IT equipment rack. The auxiliary side rack provides an effective width of 182 mm to support equipment within the auxiliary side rack. In one embodiment, the auxiliary side rack is configured to accommodate an uninterruptible power supply (UPS).

In some embodiments, the auxiliary side rack, in addition to supporting a UPS, is configured to support a battery pack, a power distribution unit and a security/environment control unit. The auxiliary side rack enables the user to dedicate the space in the IT rack for IT equipment only to improve serviceability of both IT and infrastructure.

In some embodiments, the auxiliary side rack includes three (3) 19-inch, 4U bays, each of which can be populated by a UPS, a battery pack and/or a power distribution unit.

In some embodiments, the auxiliary side rack is configured to maximize the IT space of the rack to the user, minimize the investment of users as leveraging the exist standard racks, provide separate access and operation to the power components by providing two independent doors, provide scalability and modularity to existing solutions, easy for install, operate and maintain, enable the power refresh process as a prefab power skid, and enable potential maintenance services for the infrastructure in the side rack.

In some embodiments, the auxiliary side rack is configured to support vertical mounting of UPS, Battery Pack and power distribution components. The auxiliary side rack also offers an optional integrated interface to manage those elements. By supporting the physical infrastructure elements in the sidecar, the IT space in the IT rack is available for IT equipment only, making it more serviceable for the customer.

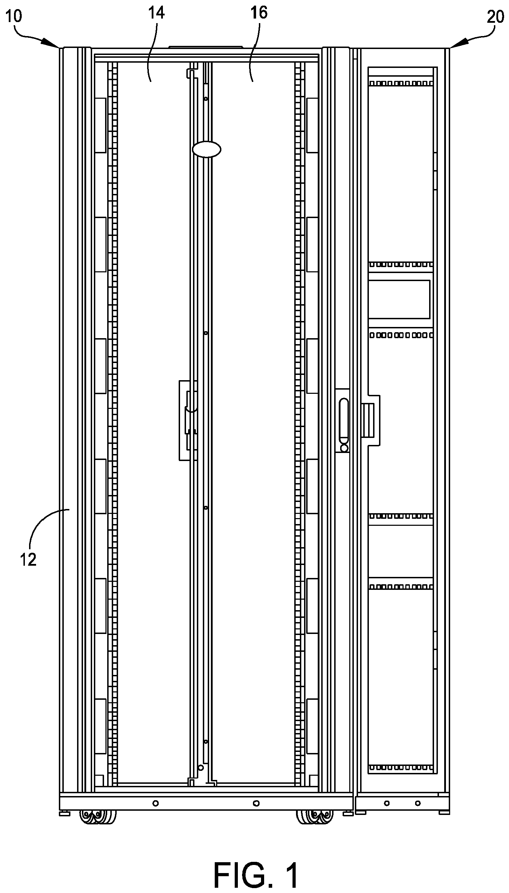

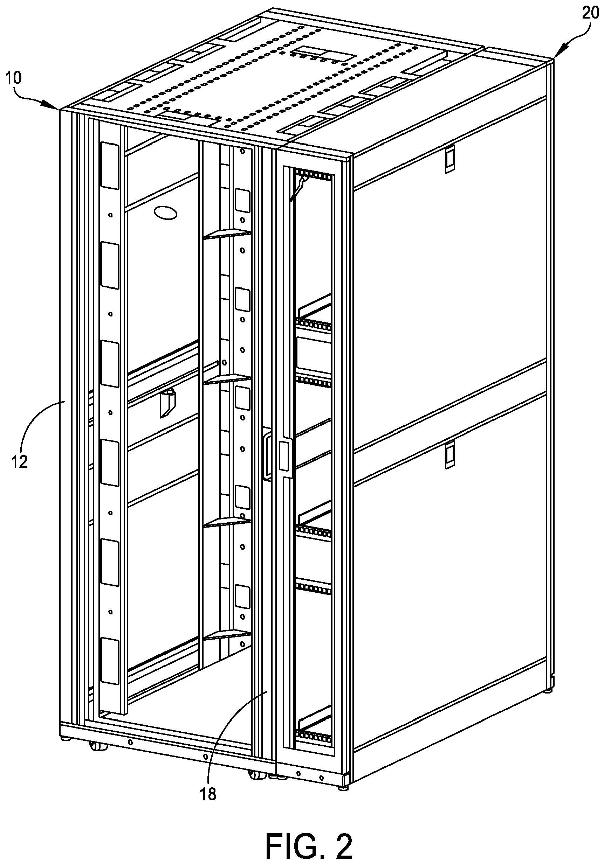

Referring to the drawings, and more particularly to FIGS. 1 and 2, a standard IT equipment rack is generally indicated at 10. A 19- or 23-inch equipment rack includes a standardized frame or enclosure to mount electronic equipment. An exemplary 19-inch rack has an overall width of 19 inches (483 millimeters (mm)) and an effective width of 17.75 inches (451 mm). An exemplary 23-inch rack has an overall width of 23 inches (584 mm). Such equipment racks are used to support electronic equipment, including but not limited to power distribution units (PDUs), UPSs, battery modules, cooling modules and the like. Further, equipment racks can be used to support other types of IT equipment, such as servers, telecommunications and networking equipment and hardware, displays and related equipment, e.g., cooling equipment. In one embodiment, the equipment rack 10 includes a chassis or frame structure 12 that defines an enclosure. The chassis 12 includes an open front having several mounting slots that are each configured to slidably receive electronic equipment. It should be noted that the equipment rack 10 can be configured to accommodate any number of pieces of electronic equipment, with the size of the mounting slots being dependent on the size of the equipment received within the mounting slots. As shown in FIG. 1, the equipment rack 10 further can be configured to include front doors 14, 16, at least one side panel, a top panel, a bottom panel and optionally back doors or a back panel. As shown in FIG. 2, the equipment rack 10 can be configured to include a single front door 18.

Also shown is an auxiliary side rack, generally indicated at 20, of an embodiment of the present disclosure. The auxiliary side rack 20 is positioned adjacent to a side of the equipment rack 10 and is provided to support power and/or IT equipment. The auxiliary side rack 20 enables cables to pass through to the equipment rack 10. In one example, the side of the equipment rack 10 adjacent to the auxiliary side rack 20 may be configured without a side panel to enable cables to pass between the equipment rack and the auxiliary side rack. In another example, the side of the equipment rack 10 adjacent to the auxiliary side rack 20 may be configured with a side panel, the side panel having one or more openings to enable cables to pass between the equipment rack and the auxiliary side rack. Moreover, the auxiliary side rack 20 is configured with passthroughs to enable cables to pass from one section to another within the auxiliary side rack 20. Details of the auxiliary side rack 20 are described in greater detail below.

In one embodiment, a width of the auxiliary side rack 20 is less than about one-half a width of the equipment rack 10. As mentioned above, the equipment rack 10 may embody a standard 19-inch rack or a standard 23-inch rack. In a particular embodiment, the auxiliary side rack 20 has an overall width of 9.21 inches (235 mm). The auxiliary side rack 20 provides an effective width of 7.17 inches (182 mm) to support equipment within the auxiliary side rack. As will be described below, the auxiliary side rack is configured to accommodate vertically oriented UPSs. Thus, the overall width of the auxiliary equipment rack 20 is at least about 3/8 (37.5%) of the overall width of the equipment rack 10, and the effective width of the auxiliary equipment rack is at least about 2/5 (40%) of the effective width of the equipment rack.

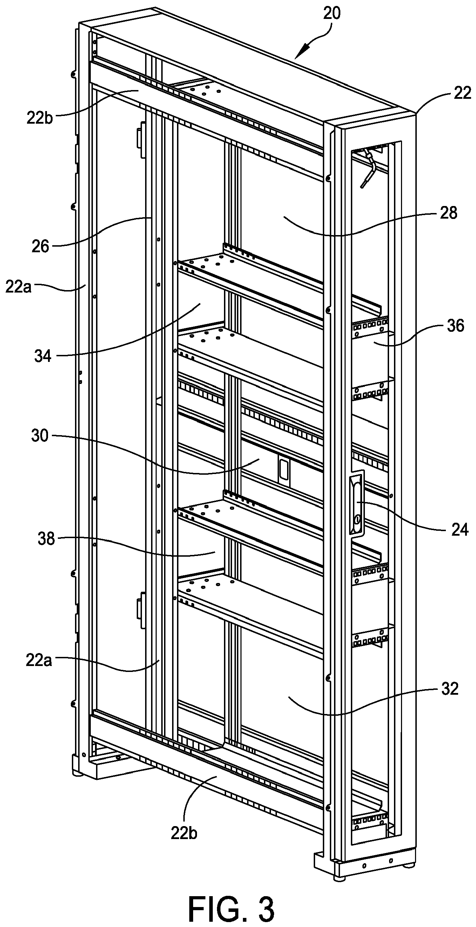

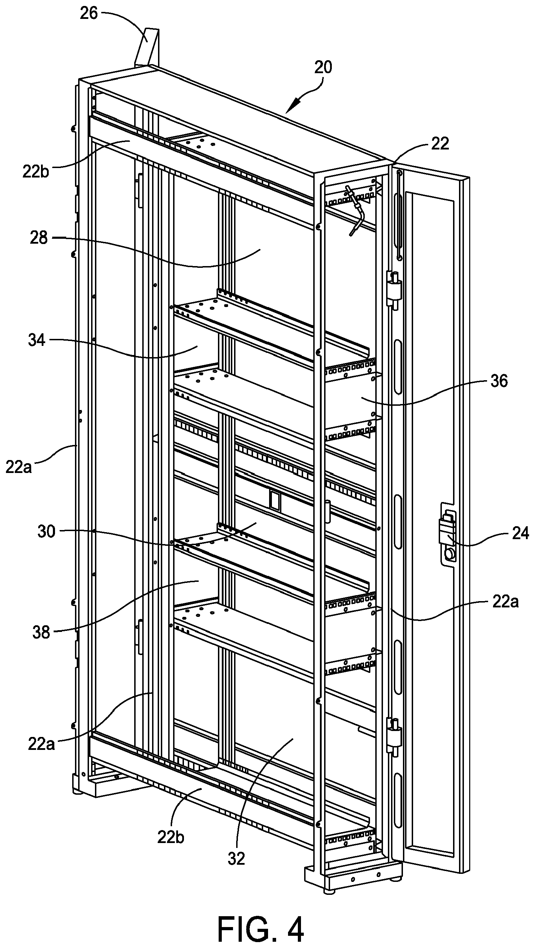

Referring to FIGS. 3 and 4, the auxiliary side rack 20 includes a chassis 22 that creates a support structure. The chassis 22 consists of a number of vertical and horizontal rail members, including vertical rail members 22a and horizontal rail members 22b, which are assembled to create the structure of the chassis. Although shown to be rectangular in shape and vertically oriented, the chassis 22 can be configured to embody another shape and/or orientation. Vertical should be understood as substantially aligned with the direction of gravity. As shown, the auxiliary side rack 20 includes a front, a back, an open side, a closed side, a top and a bottom. In one embodiment, the front and the back each include a door 24, 26, respectively, with the doors being shown closed in FIG. 3 and the doors being shown opened in FIG. 4. The doors 24, 26 can be transparent to enable visual access into the interior of the auxiliary side rack 20. The doors 24, 26 can also be opaque or solid to obfuscate or block visual access into the interior of the auxiliary side rack 20. As will be described in greater detail below, the auxiliary side rack 20 is particularly designed to support power and/or IT equipment and to allow passage of cables between within the auxiliary side rack.

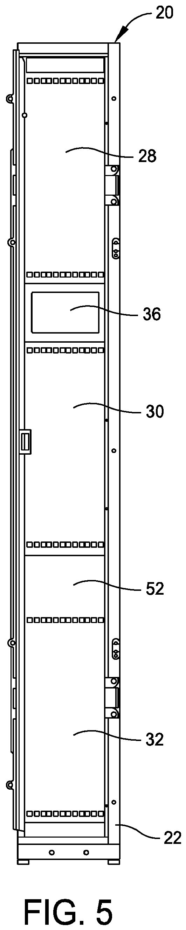

Referring to FIG. 5, the front width of the auxiliary side rack 20 is relatively narrow as compared to a front width of the equipment rack 10. At a top and a bottom of the auxiliary side rack 20 there are spaces for pass through of cables from the top and the bottom of the auxiliary side rack, respectively. Further, there are three (3) relatively larger spaces 28, 30, 32, e.g., a 4U space, which are provided to receive and support power and/or IT equipment. Also provided between two larger spaces 28, 30 positioned at an upper end of the auxiliary side rack is a passthrough 34 for cables and a display module or panel 36 at the front of the auxiliary side rack 20. When provided, the display module 36 is configured to provide information about the contents of the auxiliary side rack 20. Provided between two larger spaces 30, 32 positioned at a lower end of the auxiliary side rack 20 is another passthrough 38 for cables.

In some embodiments, the heights (distances between proximate supports) of the relatively larger spaces 28, 30, 32 and the heights of the passthroughs 34, 38, as well as the height for the display module or panel 36, may be varied to achieve a desire configuration.

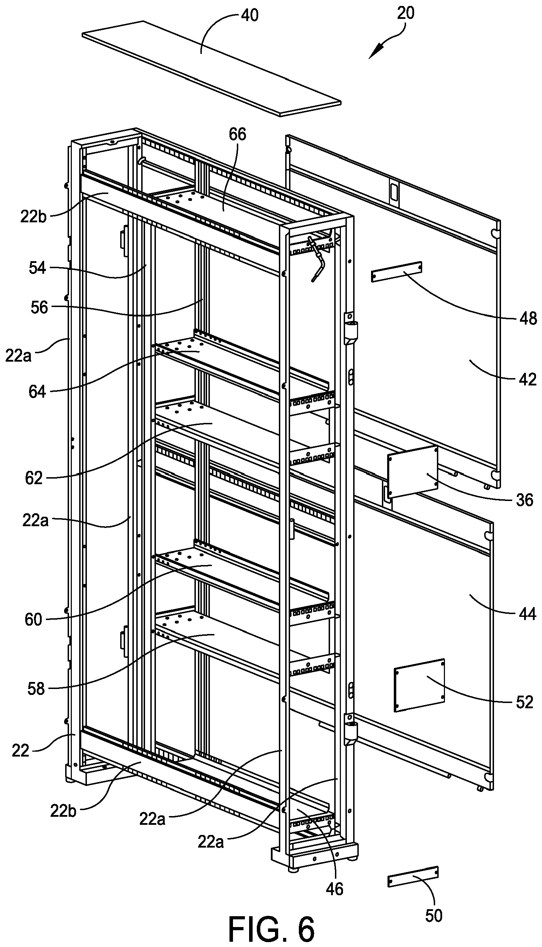

Referring to FIG. 6, the chassis 22 of the auxiliary side rack 20 is shown separated from other components of the auxiliary side rack. As shown, the auxiliary side rack 20 includes a cover 40 to enclose the top of the auxiliary side rack, two side panels 42, 44 to enclose one side of the auxiliary side rack, and a horizontal bottom tray 46 to partially enclose the bottom of the auxiliary side rack. The cover 40, the side panels 42, 44 and the horizontal bottom tray 46 are suitably secured to the chassis 22 of the auxiliary side rack 20. In one embodiment, the cover 40 includes one or more openings formed therein to enable cables pass through the cover from outside a top of the auxiliary side rack 20. Further, although two side panels 42, 44 are shown, a single panel or more than two panels can be provided to cover the side of the auxiliary side rack 20. The bottom tray 46 is shorter in length than the cover 40 to enable cables to pass through the bottom of the auxiliary side rack 20 in the space provided by the shortened bottom tray. The auxiliary side rack 20 further includes relatively small (narrow) panels 48, 50 to cover ends of smaller passthroughs provided at the top and the bottom of the auxiliary side rack. Further, the display module or cover 36 is shown as well as another smaller panel 52 to cover the end of the passthroughs 34, 38, respectively, provided between the two larger spaces 28, 30 at the upper end and between the two larger spaces 30, 32 at the lower end of the auxiliary side rack 20. The panels 48, 50, the display module or cover 36 and the panel 52 are suitably secured to the chassis 22 of the auxiliary side rack.

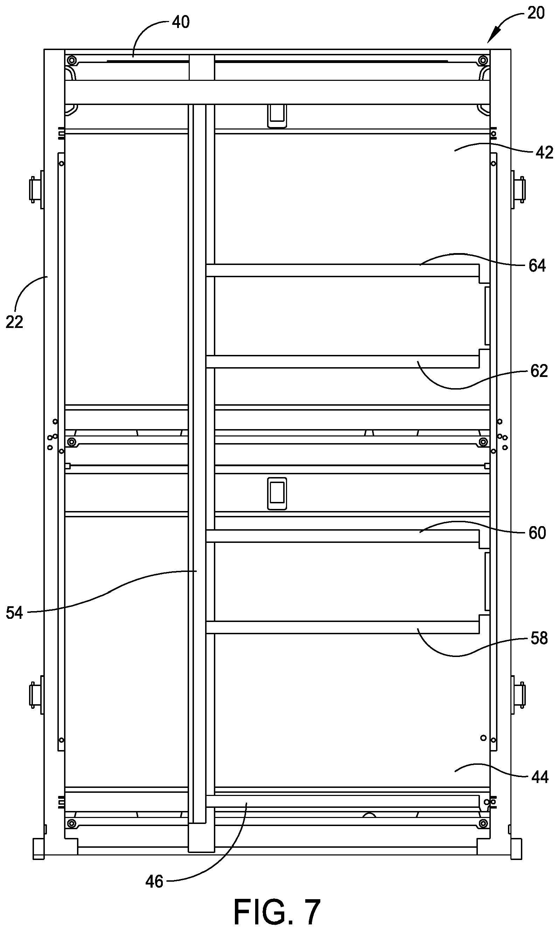

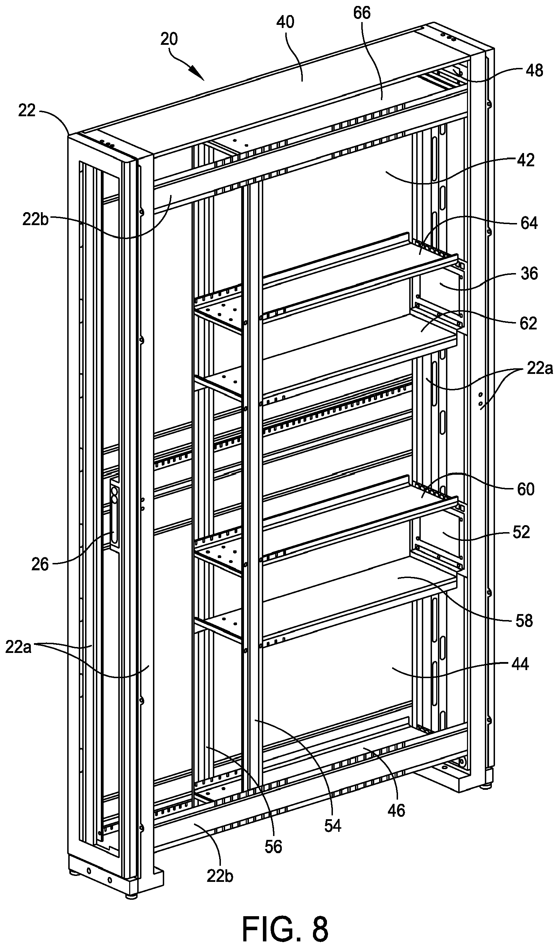

Referring additionally to FIGS. 7 and 8, in one embodiment, the auxiliary side rack 20 may include vertically oriented rear support posts 54, 56, which are provided toward the back of the auxiliary equipment rack. These posts 54, 56, along with vertical rail members 22a of the chassis 22, which may be provided at the front of the auxiliary equipment rack 20, are provided to support trays that support power and/or IT equipment. In one embodiment, there are six (6) trays, horizontal bottom tray 46 and horizontal support trays 58, 60, 62, 64, 66, with two trays provided for each relatively larger spaces. These support trays 58, 60, 62, 64, 66, 46 extend horizontally from the front of the auxiliary side rack 20 to the support posts 54, 56, which extend vertically from the top to the bottom of the auxiliary side rack. The support posts 54, 56 are suitably secured to the chassis 22. The space provided between the support posts 54, 56 and the back of the auxiliary side rack 20 can be used to support standard accessory channels for a PDU and/or cable management within the auxiliary side rack.

The arrangement is such that the bottom tray 46 and the five support trays 58, 60, 62, 64, 66 define horizontal supports configured to vertically mount equipment within the auxiliary side rack 20. Specifically, support trays 46, 58 are configured to support vertically oriented electronic equipment (e.g., a first piece of electronic equipment), support trays 60, 62 are configured to support vertically oriented electronic equipment (e.g., a second piece of electronic equipment), and support trays 64, 66 are configured to support vertically oriented electronic equipment (e.g., a third piece of electronic equipment).

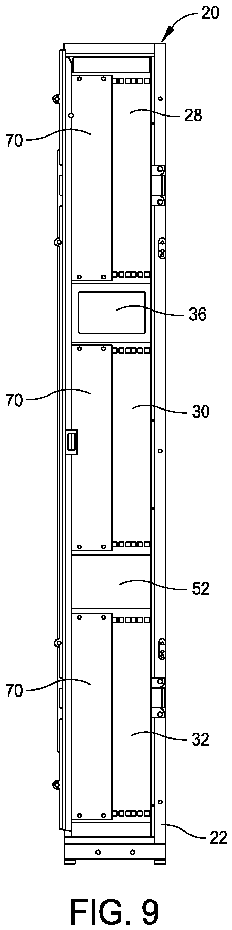

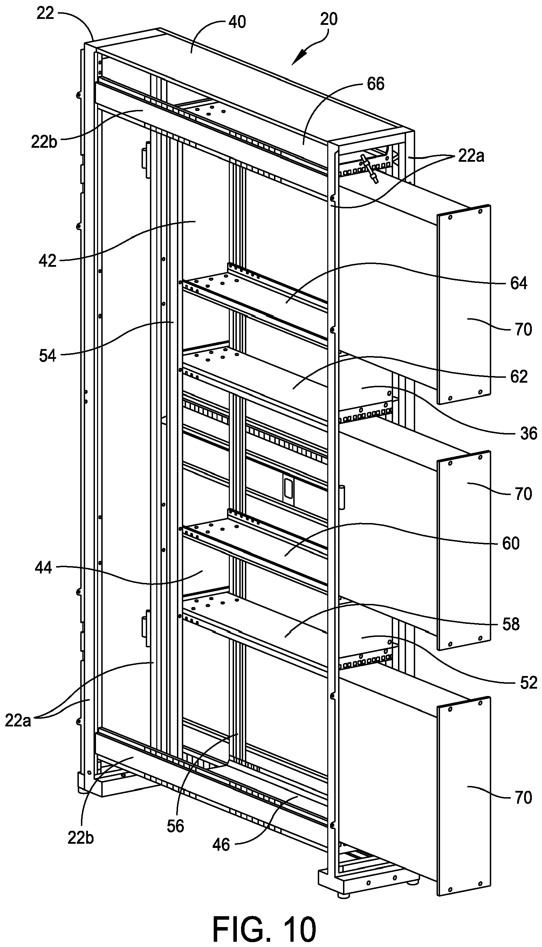

Referring to FIGS. 9 and 10, the auxiliary side rack 20 is shown having electronic equipment each indicated at 70, being installed within the auxiliary side equipment rack. As shown, the auxiliary equipment rack 20 is configured to receive the electronic equipment 70 oriented vertically within the auxiliary equipment rack. The open front of the auxiliary equipment rack 20, when the front door is open, makes it easy to install the electronic equipment 70 within the relatively larger spaces 28, 30, 32 provided. Each piece of electronic equipment 70 is configured to slide along its respective support tray 46, 60, 64 until the electronic equipment is fully inserted into the auxiliary side rack 20.

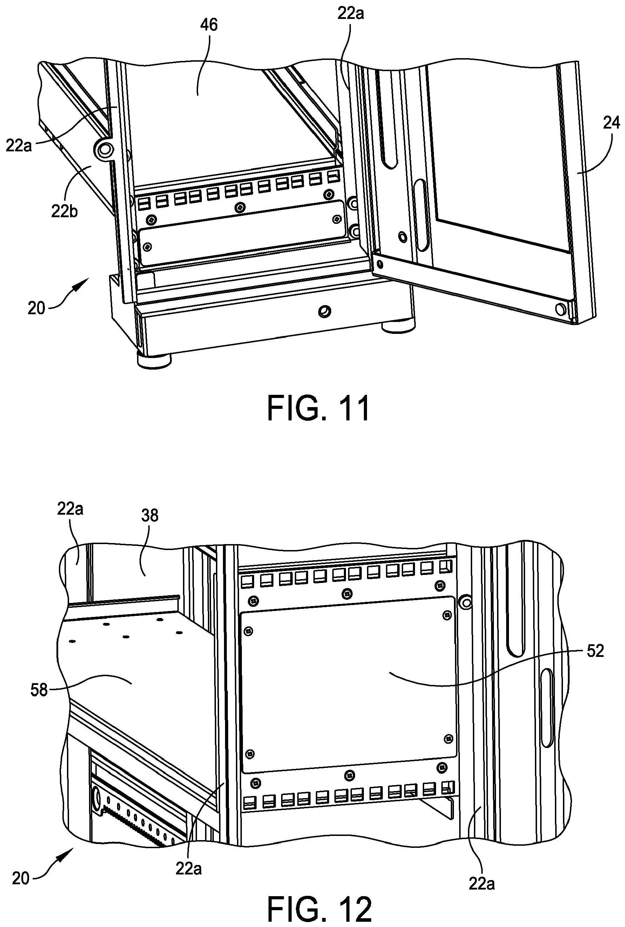

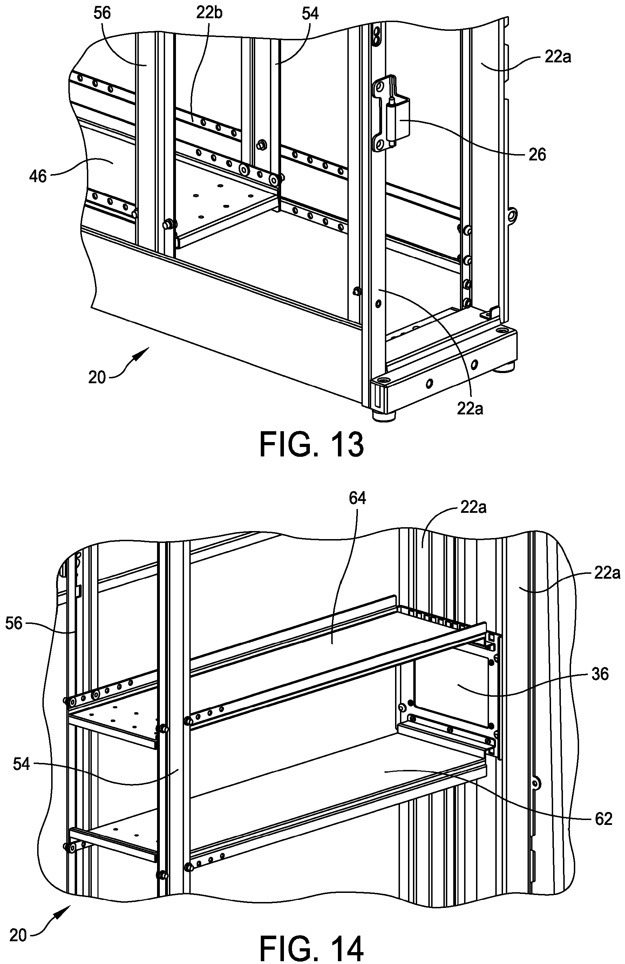

FIGS. 11-14 show various details of the construction of the auxiliary side rack 20. FIG. 11 shows a bottom portion of the auxiliary equipment rack 20 with the front door 24 in the open position. FIG. 12 shows the panel 52 used to block access to the passthrough 38 between the relatively large spaces of the auxiliary side rack. FIG. 13 shows a bottom portion of the auxiliary equipment rack 20 with the back door 26 in the closed position. FIG. 14 shows the back side of the display module or panel 36.

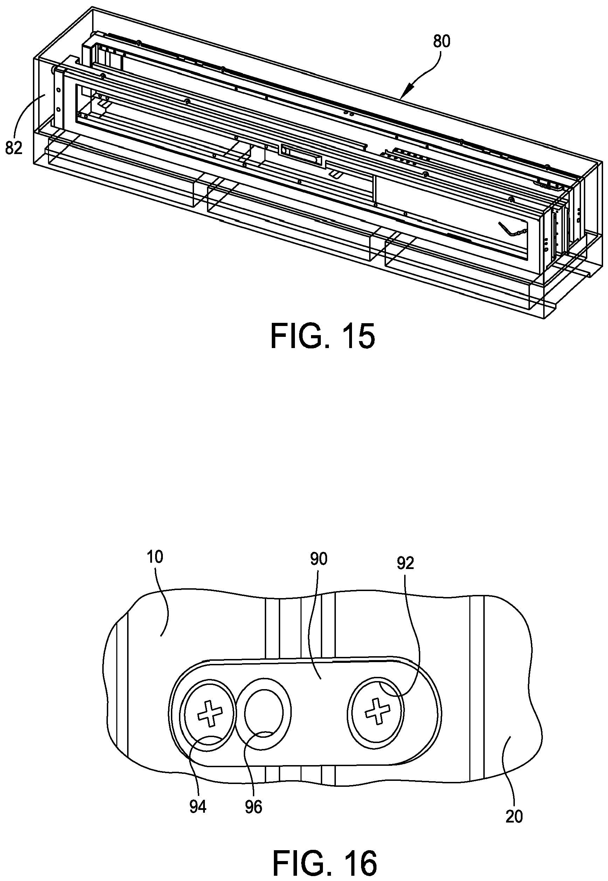

FIG. 15 shows a kit generally indicated at 80 that is provided to support the disassembled components of the auxiliary side rack 20. As shown, the components of the auxiliary side rack 20 are disposed within a package or crate 82, with the components being positioned lengthwise within the package. The reduced size of the kit 80 when compared to the assembled auxiliary side rack 20 enables the auxiliary side rack to be shipped to a remote location. Once delivered, the components of the auxiliary side rack 20 can be removed from the package and assembled on site at a desired location.

Referring to FIG. 16, a bracket 90 is shown connecting the auxiliary side rack 20 to the equipment rack 10. In one embodiment, the bracket 90 is fabricated from a suitable metal, such as stainless steel, and includes an elongated structure having at least two openings 92, 94 formed therein. An optional third opening 96 can be formed in the bracket 90. The openings 92, 94 are sized to receive fasteners, such as screw fasteners, each indicated at 98, with a first fastener securing the bracket 90 to the auxiliary side rack 10 and a second fastener securing the bracket to the equipment rack 10. Several brackets 90 can be employed to secure adjacent fronts and backs of the auxiliary side rack 20 and the equipment rack 10 so that the auxiliary side rack is firmly secured to the equipment rack. In one example, two brackets 90 can be used on the fronts of the auxiliary side rack 20 and the equipment rack 10 and two brackets can be used on the backs of the auxiliary side rack and the equipment rack, with the brackets being located adjacent to tops of and bottoms of the respective racks.

Embodiments of the present disclosure further include a method of assembling an auxiliary side rack. In one embodiment, the auxiliary side rack 20 can be provided in the form of the kit 80, with the components of the auxiliary side rack 20 being removed from the package 82. The method may include providing the chassis 22 and securing the horizontal supports, e.g., supports 46, 58, 60, 62, 64, 66, to the chassis. In one configuration, a first horizontal support and a second horizontal support are configured to be coupled to a first piece of electronic equipment, a third horizontal support and a fourth horizontal support are configured to be coupled to a second piece of electronic equipment, and a fifth horizontal support and a sixth horizontal support are configured to be coupled to a third piece of electronic equipment. With this configuration, a first cable passthrough between the second horizontal support and the third horizontal support and a second cable passthrough between the fourth horizontal support and the fifth horizontal support are provided.

In one non-limiting example, the first horizontal support includes the bottom tray 46, the second horizontal support includes support tray 58, the third horizontal support includes support tray 60, the fourth horizontal support includes support tray 62, the fifth horizontal support includes support tray 64, and the sixth horizontal support includes support tray 66. In this example, the first horizontal support 46 and the second horizontal support 58 are coupled or otherwise secured to a first piece of electronic equipment 70, the third horizontal support 60 and the fourth horizontal support 62 are coupled or otherwise secured to a second piece of electronic equipment 70, and the fifth horizontal support 64 and the sixth horizontal support 66 are coupled or otherwise secured to a third piece of electronic equipment 70. The electronic equipment can be secured to the support and/or the chassis 22 in any suitable manner used to secure electronic equipment within IT equipment racks.

The method further may include securing the display module 36 to the chassis 22 at one of the first passthrough or the second passthrough. The method further may include securing doors, including the front door 24 and the back door 26, to the chassis 22. The method further may include securing the cover 40 to chassis 22 to enclose the top of the chassis and securing the side panels, including panels 42, 44, to the chassis 22 to enclose a side of the chassis. The chassis 22 of the auxiliary side rack 20 may be secured to the equipment rack 10 with one or more brackets 90. The brackets 90 are used to secure a side rack to a side of the equipment rack.

In one embodiment, a space between the first horizontal support and the second horizontal support is 4U, a space between the third horizontal support and the fourth horizontal support is 4U, and a space between the fifth horizontal support and the sixth horizontal support is 4U.

In the shown embodiment, the auxiliary side rack 20 is mounted on one side of the equipment rack 10. In some embodiments, the auxiliary side rack 20 can be mounted on the other side of the equipment rack 10. In another embodiment, the equipment rack 10 can have an auxiliary side rack 20 mounted on both sides of the equipment rack.

In some embodiments, the outer dimensions of the auxiliary side rack 20 are 235.7 mm in width by 1,200.0 mm in depth by 1,955.0 mm in height. The inner dimensions of the three relatively large spaces of the auxiliary side rack 20 are 182.7 mm in width by 725.0 mm in depth by 451.0 mm in height. The auxiliary side rack 20 can be configured in any number of ways and dimensions depending on an intended purpose.

Further examples are provided in the following clauses.

Clause 1. A side rack, comprising:
a chassis;
a first horizontal support coupled to the chassis, the first horizontal support being configured to be coupled to a first piece of equipment;
a second horizontal support coupled to the chassis, the second horizontal support being configured to be coupled to the first piece of equipment; and
a third horizontal support coupled to the chassis, the third horizontal support being configured to be coupled to a second piece of equipment.

Clause 2. The side rack of clause 1, further comprising a first cable passthrough between the second horizontal support and the third horizontal support.

Clause 3. The side rack of clause 2, wherein a space between the first horizontal support and the second horizontal support is 4U.

Clause 4. The side rack of clause 2, further comprising a fourth horizontal support coupled to the chassis, the fourth horizontal support being configured to be coupled to the second piece of equipment.

Clause 5. The side rack of clause 4, wherein a space between the third horizontal support and the fourth horizontal support is 4U.

Clause 6. The side rack of clause 4, further comprising a fifth horizontal support coupled to the chassis, the fifth horizontal support being configured to be coupled to a third piece of equipment.

Clause 7. The side rack of clause 6, further comprising a second cable passthrough between the fourth horizontal support and the fifth horizontal support.

Clause 8. The side rack of clause 7, further comprising a display module provided at one of the first passthrough or the second passthrough.

Clause 9. The side rack of clause 6, further comprising a sixth horizontal support coupled to the chassis, the sixth horizontal support being configured to be coupled to the third piece of equipment.

Clause 10. The side rack of clause 9, wherein a space between the fifth horizontal support and the sixth horizontal support is 4U.

Clause 11. The side rack of clause 1, wherein the chassis includes at least one of a front door or a back door.

Clause 12. The side rack of clause 1, wherein the chassis includes a cover to enclose a top of the chassis, the cover including at least one opening to allow a cable to pass therethrough.

Clause 13. The side rack of clause 1, wherein the chassis includes one or more side panels to enclose a side of the chassis.

Clause 14. The side rack of clause 1, further comprising one or more brackets configured to secure the chassis to an equipment rack.

Clause 15. The side rack of clause 14, wherein the one or more brackets are used to secure the side rack to a side of the equipment rack.

Clause 16. The side rack of clause 1, wherein the chassis includes vertical rail members and horizontal rail members.

Clause 17. The side rack of clause 16, wherein the chassis further includes a first support post and a second support post located toward a back of the chassis, the first horizontal support, the second horizontal support and the third horizontal support each extending from a front of the chassis to the first support post and the second support post.

Clause 18. The side rack of clause 17, wherein a space between ends of the first support post and the second support post and the back of the chassis is configured to support standard accessory channels for a PDU and/or cable management.

Clause 19. The side rack of clause 1, wherein the first horizontal support and the second horizontal support are configured to vertically mount the first piece of equipment.

Clause 20. The side rack of clause 1, wherein the third horizontal support is configured to vertically mount the second piece of equipment.

Clause 21. The side rack of clause 1, wherein components of the side rack are configured to be packaged in kit form.

Clause 22. The side rack of clause 1, wherein the side rack has a width less than about one-half a width of the equipment rack.

Clause 23. A method of assembling a side rack, the method comprising:
providing a chassis;
securing a first horizontal support to the chassis, the first horizontal support being configured to be coupled to a first piece of equipment;
securing a second horizontal support to the chassis, the second horizontal support being configured to be coupled to the first piece of equipment; and
securing a third horizontal support to the chassis, the third horizontal support being configured to be coupled to a second piece of equipment.

Clause 24. The method of clause 23, further comprising providing a first cable passthrough between the second horizontal support and the third horizontal support.

Clause 25. The method of clause 24, further comprising securing a fourth horizontal support to the chassis, the fourth horizontal support being configured to be coupled to the second piece of equipment.

Clause 26. The method of clause 25, further comprising securing a fifth horizontal support to the chassis, the fifth horizontal support being configured to be coupled to a third piece of equipment.

Clause 27. The method of clause 26, further comprising providing a second cable passthrough between the fourth horizontal support and the fifth horizontal support.

Clause 28. The method of clause 27, further comprising providing a display module at one of the first passthrough or the second passthrough.

Clause 29. The method of clause 26, further comprising securing a sixth horizontal support to the chassis, the sixth horizontal support being configured to be coupled to the third piece of equipment.

Clause 30. The method of clause 23, further comprising securing the chassis to an equipment rack.

Having thus described several aspects of at least one embodiment, it is to be appreciated various alterations, modifications, and improvements will readily occur to those skilled in the art. Such alterations, modifications, and improvements are intended to be part of this disclosure and are intended to be within the scope of the disclosure. Accordingly, the foregoing description and drawings are by way of example only.

## Claims

1. A side rack, comprising:
a chassis;
a first horizontal support coupled to the chassis, the first horizontal support being configured to be coupled to a first piece of equipment;
a second horizontal support coupled to the chassis, the second horizontal support being configured to be coupled to the first piece of equipment; and
a third horizontal support coupled to the chassis, the third horizontal support being configured to be coupled to a second piece of equipment.

2. The side rack of claim 1, further comprising a first cable passthrough between the second horizontal support and the third horizontal support.

3. The side rack of claim 2, further comprising a fourth horizontal support coupled to the chassis, the fourth horizontal support being configured to be coupled to the second piece of equipment.

4. The side rack of claim 3, further comprising a fifth horizontal support coupled to the chassis, the fifth horizontal support being configured to be coupled to a third piece of equipment.

5. The side rack of claim 4, further comprising a sixth horizontal support coupled to the chassis, the sixth horizontal support being configured to be coupled to the third piece of equipment.

6. The side rack of claim 5, wherein one or more of a space between the first horizontal support and the second horizontal support, a space between the third horizontal support and the fourth horizontal support, and a space between the fifth horizontal support and the sixth horizontal support, is 4U.

7. The side rack of any of the claims 4 to 6, further comprising a second cable passthrough between the fourth horizontal support and the fifth horizontal support.

8. The side rack of claim 7, further comprising a display module provided at one of the first passthrough or the second passthrough.

9. The side rack of any of the above claims, wherein the chassis includes one or more of:
a front door;
a back door;
a cover to enclose a top of the chassis, the cover including at least one opening to allow a cable to pass therethrough; and
one or more side panels to enclose a side of the chassis.

10. The side rack of any of the above claims, further comprising one or more brackets configured to secure the chassis to an equipment rack.

11. The side rack of any of the above claims, wherein the chassis includes vertical rail members and horizontal rail members.

12. The side rack of claim 11, wherein the chassis further includes a first support post and a second support post located toward a back of the chassis, the first horizontal support, the second horizontal support and the third horizontal support each extending from a front of the chassis to the first support post and the second support post.

13. The side rack of claim 12, wherein a space between ends of the first support post and the second support post and the back of the chassis is configured to support standard accessory channels for a PDU and/or cable management.

14. The side rack of any of the above claims, wherein the first horizontal support and the second horizontal support are configured to vertically mount the first piece of equipment, or wherein the third horizontal support is configured to vertically mount the second piece of equipment, or wherein components of the side rack are configured to be packaged in kit form, or wherein the side rack has a width less than about one-half a width of the equipment rack.

15. A method of assembling a side rack, the method comprising:
providing a chassis;
securing a first horizontal support to the chassis, the first horizontal support being configured to be coupled to a first piece of equipment;
securing a second horizontal support to the chassis, the second horizontal support being configured to be coupled to the first piece of equipment; and
securing a third horizontal support to the chassis, the third horizontal support being configured to be coupled to a second piece of equipment.
